(19) **Europäisches Patentamt / European Patent Office / Office européen des brevets**

(11) **EP 3 863 223 A1**

(12) # EUROPEAN PATENT APPLICATION
published in accordance with Art. 153(4) EPC

(43) Date of publication:
**11.08.2021 Bulletin 2021/32**

(51) Int Cl.:
**H04L 12/24** *(2006.01)*

(21) Application number: **18937297.2**

(22) Date of filing: **30.10.2018**

(86) International application number:
**PCT/CN2018/112681**

(87) International publication number:
**WO 2020/077672 (23.04.2020 Gazette 2020/17)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **17.10.2018 CN 201811210357**

(71) Applicant: **Wangsu Science & Technology Co., Ltd.**
**Shanghai 201800 (CN)**

(72) Inventor: **ZHAO, Rui**
**Shanghai 201800 (CN)**

(74) Representative: **De Arpe Tejero, Manuel**
**Arpe Patentes y Marcas**
**Alcalá, 26, 5ª Planta**
**28014 Madrid (ES)**

(54) **METHOD AND DEVICE FOR TRAINING SERVICE QUALITY EVALUATION MODEL**

(57)    The present invention provides a training method and a training apparatus for a service quality assessment model. The method includes: collecting machine performance data, network characteristics data, and quality monitoring data of service nodes according to a fixed cycle; determining an eigenvalue based on the machine performance data and the network characteristics data; determining target quality data based on the quality monitoring data; using the eigenvalue and the target quality data to establish a training dataset; and using the training dataset to construct the service quality assessment model. In the embodiments of the present invention, the machine performance data, the network characteristics data, and the quality monitoring data are correlated through a feature engineering function of a deep neural network. Training is performed in combination with backward propagation to fit a non-linear relationship. Time consumed in manually performing feature engineering is reduced. At the same time, an accuracy of service quality assessment is improved.

FIG. 3

**Description**

FIELD OF THE DISCLOSURE

The present invention relates to the field of content delivery network (CDN) technology, more particularly, relates to a training method and an apparatus for a service quality assessment model.

BACKGROUND

The acronym CND refers to content delivery network, also known as, content distribution network. A CDN is a layer of an intelligent virtual network formed by disposing node servers throughout an entire network between a service provider and its service requesters. To ensure a high service quality, a CDN system tracks the service quality provided to its clients in real-time, timely discovers and replaces faulty nodes, and avoids degradation of the service quality caused by machine or network reasons.

Currently, one way to assess the service quality of the CDN system is to assess the service quality by using indicators such as machine performances and network conditions. This type of assessment relies heavily on experience of operation personnel. The machine performances and the network conditions may include a large amount of multi-dimensional data. Pre-processing the large amount of the multi-dimensional data takes substantial amount of time and labor cost. Moreover, human judgements are prone to errors. Thus, it is difficult to quickly and precisely track service quality issues. On the other hand, if assessments are purely based on the rules worked out by human experience rules, whether it is for upfront investments or ongoing maintenance or both, the engineering project will require substantial investments in time and manpower. In practical applications, this type of assessments is unable to adapt to constantly changing connected machines and networks.

Another way to assess the service quality is to analyze server access logs, for example, to calculate indicators such as a pausing rate. Assessing the service quality based on the server access logs requires substantial computing resource to fully analyze the access logs and results in a substantially high cost of equipment and bandwidth for internal operation and maintenance. On the other hand, this type of assessments is highly coupled with service types. Each of the service types requires substantially different assessment indicators. It is impossible to form a uniform standard, thereby making it difficult to manage internally.

BRIEF SUMMARY OF THE DISCLOSURE

To solve the problem of the existing technology, the embodiments of the present invention provide a training method and a training apparatus for a service quality assessment model. The technical solution includes the following.

One aspect of the present invention provides a training method for a service quality assessment model applicable for a model training node. The method includes: collecting machine performance data, network characteristics data, and quality monitoring data of service nodes according to a fixed cycle; determining an eigenvalue based on the machine performance data and the network characteristics data; determining target quality data based on the quality monitoring data; using the eigenvalue and the target quality data to establish a training dataset; and using the training dataset to construct the service quality assessment model.

Optionally, each service quality assessment model is applicable for assessing one service type; and correspondingly, collecting the quality monitoring data of the service nodes according to the fixed cycle includes: collecting, according to the fixed cycle, the quality monitoring data of the service nodes corresponding to one or more application services belonging to a service type applicable for the service quality assessment model.

Optionally, the machine performance data include a CPU utilization rate, a memory utilization rate, and input/output information; and the network characteristics data include ping data, poll data, and a downloading speed.

Optionally, a monitoring node periodically sends testing signals to the service nodes to obtain the network characteristics data; and correspondingly, collecting the network characteristics data of the service nodes according to the fixed cycle includes: collecting the network characteristics data of the service nodes from the monitoring node according to the fixed cycle.

Optionally, before determining the eigenvalue based on the machine performance data and the network characteristics data, the method further includes: screening missing values and corrupted values from the machine performance data, the network characteristics data, the quality monitoring data; and replacing the missing values and the corrupted values with correct values.

Optionally, screening the missing values and the corrupted values from the machine performance data, the network characteristics data, the quality monitoring data includes using a clustering algorithm or configuring a confidence range after the collected data are standardized to screen the missing values and the corrupted values from the machine performance data, the network characteristics data, the quality monitoring data; and replacing the corrupted values with the correct values includes using a k-NN method or data collected in adjacent collection cycles to replace the corrupted values.

Optionally, the eigenvalue includes the machine performance data, one or more of mean values, median values, or variance values of various dimensions of the machine performance data, the network characteristics data, and one or more of mean values, median values, or variance values of various dimensions of the network characteristics data.

Optionally, determining the target quality data based on the quality monitoring data includes: determining assessment indicators of service quality based on the service type applicable for the service quality assessment model; and using the quality monitoring data to calculate values of the assessment indicators and determining the values of the assessment indicators as the target quality data.

Optionally, using the training dataset to construct the service quality assessment model includes: using the training dataset to train a deep neural network to construct the service quality assessment model, where the deep neural network is a deep residual network.

Optionally, the training dataset includes a plurality of training samples; and each training sample includes the eigenvalue of $m$ number of the temporal steps and the target quality data, where $m$ is a positive integer.

Optionally, using the training dataset to train the deep residual network includes: inputting the eigenvalues of the training samples to the deep residual network in turn to obtain quality data; determining an error between the quality data and the target quality data; and backward propagating the error to optimize hyperparameters of a model.

Optionally, the deep residual network includes an input layer, a first total connection layer, a convolution layer, a preset number of residual blocks, a second total connection layer, and an output layer.

Optionally, using the training dataset to train the deep residual network includes: inputting the eigenvalues of the training samples to the first total connection layer to be divided and compressed, and outputting new features.

Optionally, the convolution layer has a plurality of channels.

Optionally, using the training dataset to train the deep residual network further includes: inputting data outputted from the convolution layer to the preset number of residual blocks in turn for further processing, where data processing in each residual block includes: inputting, in turn, data inputted to the residual block to a 1 * 1 convolution layer having $a$ number of channels, a 1*3 convolution layer having $b$ number of channels, and a 1*1 convolution layer having c number of channels, wherein $a$, $b$, and $c$ are positive integers; summing data outputted from the 1*1 convolution layer having c number of channels and data inputted to the 1*1 convolution layer having $a$ number of channels; and exciting the summed data by a Relu function.

Optionally, using the training dataset to train the deep residual network further includes: inputting data outputted from the last one of the preset number of residual blocks to the second total connection layer to perform a non-linear transformation to obtain the quality data.

Optionally, the method further includes using the eigenvalue and the target quality data to establish a testing dataset; and using the training dataset to construct the service quality assessment model includes: according to the training dataset established based on history data, performing model training; according to the testing dataset, validating an effectiveness of fitting a trained model; if the effectiveness does not satisfy a preset requirement, adjusting the hyperparameters and repeating the model training iteratively; if the effectiveness satisfies the preset requirement, terminating the model training to obtain the service quality assessment model; and using the training dataset established based on real-time data to continue to train the service quality assessment model to optimize the hyperparameters of the service quality assessment model.

Optionally, a relationship between inputted data and outputted result established by the service quality assessment model is a non-linear relationship.

Optionally, the model training node is a single server or a group of servers.

Another aspect of the present invention provides a training apparatus for a service quality assessment model. The apparatus includes: a collecting module configured to collect machine performance data, network characteristics data, and quality monitoring data of service nodes according to a fixed cycle; a processing module configured to determine an eigenvalue based on the machine performance data and the network characteristics data, to determine target quality data based on the quality monitoring data, and to use the eigenvalue and the target quality data to establish a training dataset; and a training module configured to use the training dataset to construct the service quality assessment model.

Optionally, each service quality assessment model is applicable for assessing one service type; and correspondingly, the collecting module is configured to collect, according to the fixed cycle, the quality monitoring data of the service nodes corresponding to one or more application services belonging to a service type applicable for the service quality assessment model.

Optionally, the processing module is further configured to: screen missing values and corrupted values from the machine performance data, the network characteristics data, the quality monitoring data; and replace the missing values and the corrupted values with correct values.

Optionally, the eigenvalue includes the machine performance data, one or more of mean values, median values, or variance values of various dimensions of the machine performance data, the network characteristics data, and one or more of mean values, median values, or variance values of various dimensions of the network characteristics data.

Optionally, the training module is further configured to use the training dataset to train a deep neural network to construct the service quality assessment model, wherein the deep neural network is a deep residual network.

Optionally, the training dataset includes a plurality of training samples; each training sample includes the eigenvalue of *m* number of the temporal steps and the target quality data, where *m* is a positive integer; and the training module is further configured to: input the eigenvalues of the training samples to the deep residual network in turn to obtain quality data; determine an error between the quality data and the target quality data; and backward propagate the error to optimize hyperparameters of a model.

Optionally, the deep residual network includes an input layer, a first total connection layer, a convolution layer, a preset number of residual blocks, a second total connection layer, and an output layer.

Optionally, the training module is further configured to input the eigenvalues of the training samples to the first total connection layer to be divided and compressed, and to output new features.

Optionally, the convolution layer has a plurality of channels.

Optionally, the training module is further configured to input data outputted from the convolution layer to the preset number of residual blocks in turn for further processing, where data processing in each residual block includes: inputting, in turn, data inputted to the residual block to a 1*1 convolution layer having *a* number of channels, a 1*3 convolution layer having *b* number of channels, and a 1*1 convolution layer having *c* number of channels, wherein *a, b,* and *c* are positive integers; summing data outputted from the 1*1 convolution layer having *c* number of channels and data inputted to the 1*1 convolution layer having *a* number of channels; and stimulating the summed data by a Relu function.

Optionally, the training module is further configured to input data outputted from the last one of the preset number of residual blocks to the second total connection layer to perform a non-linear transformation to obtain the quality data.

Optionally, the processing module is further configured to use the eigenvalue and the target quality data to establish a testing dataset; and the training module is further configured to: according to the training dataset established based on history data, perform model training; according to the testing dataset, validate an effectiveness of fitting a trained model; if the effectiveness does not satisfy a preset requirement, adjust the hyperparameters and repeating the model training iteratively; if the effectiveness satisfies the preset requirement, terminate the model training to obtain the service quality assessment model; and use the training dataset established based on real-time data to continue to train the service quality assessment model to optimize the hyperparameters of the service quality assessment model.

The embodiments of the present invention may have the following beneficial effects.

(1) In the embodiments of the present invention, indicators such as the machine performance data and the network characteristics data may be correlated with service quality through a feature engineering function of the deep neural network. Training is performed in combination with backward propagation to fit the non-linear relationship. Time consumed in manually performing feature engineering is reduced. At the same time, an accuracy of the service quality assessment is improved.

(2) The model according to the embodiments of the present invention may constantly adapt to the changing online real-time data by adopting an incremental training method while combining more dimensional features for training. As such, a service cluster having a better service quality may be determined in real-time through model prediction and may be recommended to a dispatching system to ensure the system to operate stably with high quality services.

(3) In the embodiments of the present invention, the machine performance data, the network characteristics data, and the quality monitoring data may be used to train the model to learn the non-linear relationship among the machine performance data and the network characteristics data. When the model is used to assess the service quality of the service system, only the machine performance data and the network characteristics data of the service system are required to be inputted. Compared with the method of assessing the service quality by analyzing the server access logs, the present invention may reduce an amount of data to be inputted, substantially reduce the computing resource and bandwidth required by the service quality assessment, increase an efficiency of the service quality assessment, and reduce operation cost. Because the data to be inputted to the model are decoupled from specific businesses, a general-purpose standard may be formed for the service quality assessment, thereby facilitating management of any service system.

(4) In the embodiments of the present invention, residual blocks are introduced in the deep neural network model to mitigate network degradation caused by a substantial network depth. As such, the deep neural network may be configured to have the substantial network depth to facilitate the deep neural network to transform the machine performance data and the network characteristics data to higher-level features. The higher-level features may be used to learn the service quality of the limited number of the application services. The learned model may use the machine performance data and the network characteristics data as model input without relying on the quality monitoring data to determine the assessment indicators of the service quality. Thus, the present invention may be used in the service quality assessment of the application services of which the assessment indicators are impossible or difficult to be determined precisely.

## BRIEF DESCRIPTION OF THE DRAWINGS

In order to more clearly illustrate the technical solutions in the embodiments of the present invention, drawings used in the description of the embodiments will be briefly described below. Obviously, the drawings in the following description are only some embodiments of the present invention. Other embodiments may also be obtained by those of ordinary skill in the art without inventive work.

FIG. 1 illustrates a schematic diagram of an exemplary network framework according to disclosed embodiments;

FIG. 2 illustrates a schematic diagram of another exemplary network framework according to disclosed embodiments;

FIG. 3 illustrates a flow chart of an exemplary training method for a service quality assessment model according to disclosed embodiments;

FIG. 4 illustrates a flow chart of an exemplary service quality assessment method according to disclosed embodiments;

FIG. 5 illustrates a block diagram of an exemplary training apparatus for the service quality assessment model according to disclosed embodiments; and

FIG. 6 illustrates a block diagram of an exemplary service quality assessment apparatus according to disclosed embodiments.

## DETAILED DESCRIPTION

To make the objectives, technical solutions, and advantages of the present invention clearer, the following further describes the embodiments of the present invention in details with reference to the accompanying drawings.

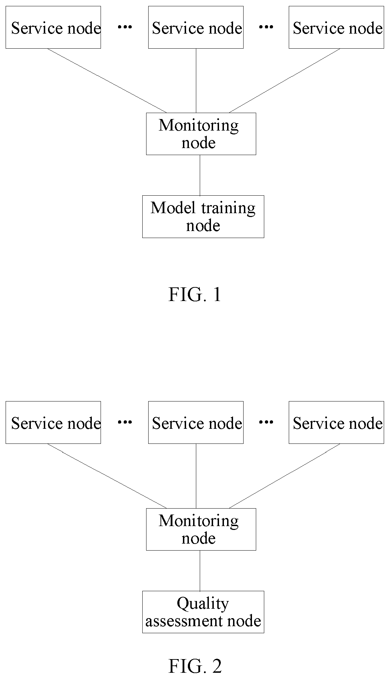

The present invention provides a training method for a service quality assessment model. The method may be applied to a network framework as shown in FIG. 1. The network framework includes service nodes, a monitoring node, and a model training node. The service nodes are nodes that provide services for users in a CDN system. Connected to the service nodes, the monitoring node is configured to monitor network conditions between the monitoring node and the service nodes by sending testing signals to the service nodes, and to generate network characteristics data. The monitoring node is further configured to collect machine performance data, network characteristics data, and quality monitoring data from the service nodes. Connected to the monitoring node, the model training node is configured to collect the machine performance data, the network characteristics data, and the quality monitoring data from the monitoring node to establish a training dataset, and to use the training dataset to train a service equality assessment model. The monitoring node may be one or more nodes. When multiple monitoring nodes are present, each of the multiple monitoring nodes may be responsible for monitoring a portion of the service nodes. The model training node may be a single server or a group of servers.

The present invention also provides a service quality assessment method. The method may use the trained service quality assessment model to assess the service quality. The method may be applied to a network framework as shown in FIG. 2. The network framework includes service nodes, a monitoring node, and a quality assessment node. The monitoring node is configured to monitor network conditions between the monitoring node and the service nodes and to generate network characteristics data. The monitoring node is further configured to collect machine performance data from the service nodes. Connected to the monitoring node, the quality assessment node is configured to collect the machine performance data and the network characteristics data from the monitoring node, and then to use the collected data and the trained service equality assessment model to assess the service quality of the CDN system. The quality assessment node may be a single server or a group of servers. The model training node and the quality assessment node may be a same node or different nodes.

It should be noted that the embodiments of the present invention are applicable to assessing not only the service quality of the CDN system, but also the service quality of a single server node as well as the service quality of other service system or server group formed by multiple server nodes. The embodiments of the present invention do not limit the scope of suitable applications.

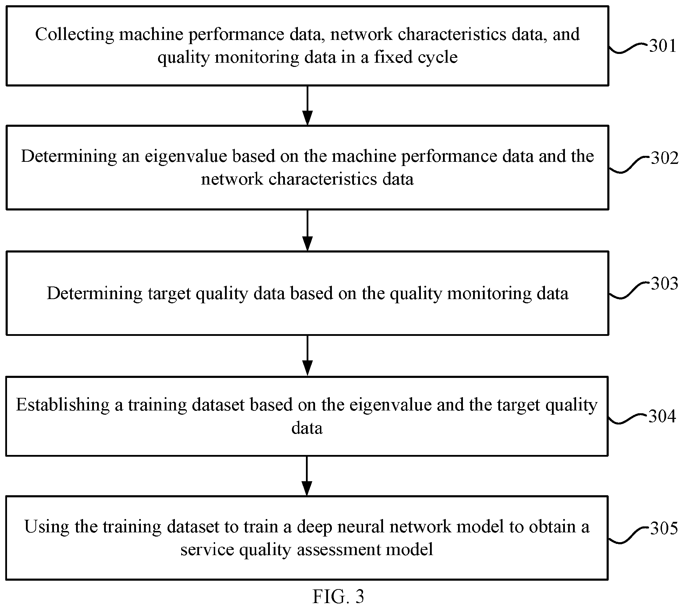

FIG. 3 illustrates a flow chart of an exemplary training method for a service quality assessment model according to disclosed embodiments. The method may be applied to the model training node. That is, the method is implemented at the model training node. Specifically, the method may include the following steps.

Step 301: collecting machine performance data, network characteristics data, and quality monitoring data in a fixed cycle.

In a process of training the service quality assessment model, an eigenvalue may be inputted to train the model to obtain an output result. Then, parameters of the model may be adjusted based on an error between the output result and an actual result. The training continues on the adjusted model. The training continues iteratively until a non-linear relationship between the input data and the output result is established, i.e., the service quality assessment model is obtained. The data for determining the eigenvalue may include the machine performance data and the network characteristics data. In one embodiment, the data for establishing the non-linear relationship with the service quality may further include other data. The embodiments of the present invention do not limit the data for establishing the non-linear relationship with the service quality. In one embodiment, the machine performance data, the network characteristics data, and the quality monitoring data may be collected in a fixed cycle from each service node in the CDN system. The machine performance data may include a CPU utilization rate, a memory utilization rate, and input/output information, etc. In an operational CDN system, the monitoring node periodically sends testing signals to the service nodes to detect the network conditions between the monitoring node and the service nodes and to obtain the network characteristics data. The network characteristics data may include ping data (packet internet groper), poll data, and a downloading speed, etc.

The machine performance data and the quality monitoring data need to be obtained from the service nodes. To avoid directly collecting the data from the service nodes, which requires establishing substantial number of links to the service nodes in the CDN system, the model training node may rely on the monitoring node to periodically collect the machine performance data and quality monitoring data from the service nodes. Then, the model training node may obtain the machine performance data, the network characteristics data, and the quality monitoring data from the monitoring node in the fixed cycle. In one embodiment, the service nodes and the monitoring node may send the data required by the model training node to a distributed storage system. Then, the model training node may obtain the data from the distributed storage system in the fixed cycle. The embodiments of the present invention do not limit how raw data are collected.

When the quality monitoring data are collected, the quality monitoring data may be obtained from log information of the service nodes. The quality monitoring data may be used to calculate the assessment indicators reflecting a level of the service quality. The quality monitoring data may include a request response time, and a size of requested content, etc.

The method provided by the embodiments of the present invention may be used to train the service quality assessment model applicable for a service type. The service type may include a plurality of application services. Based on the service type for the service quality assessment model, the quality monitoring data corresponding to the application service included in the service type may be selected to perform a model training. In one embodiment, a general-purpose model training method may be used to train various service quality assessment models for various service types. When the quality monitoring data are collected, the quality monitoring data corresponding to one or more application services may be collected from the service nodes. The one or more application services may belong to the service type applicable for the service quality assessment model. In other words, the quality monitoring data may be collected for a limited number of the application services instead of all the application services included in the service type. For example, a to-be-trained model is applicable for the service type A. The service type A may include an application service A1, an application service A2, ..., an application service An. When the quality monitoring data are collected, the quality monitoring data corresponding to the application service A1 may be collected for a subsequent model training. As such, a data transmission load when the quality monitoring data are collected, and a subsequent data processing load may be reduced. In one embodiment, the quality monitoring data corresponding to a wide range of the application services may be collected, and the quality monitoring data corresponding to the application services pre-configured in the service nodes may be obtained from the collected quality monitoring data to perform the model training based on the obtained data.

In one embodiment, the machine performance data, the network characteristics data, and the quality monitoring data may be collected from a plurality of CDN systems.

After the raw data are collected, an ETL pre-processing process may be performed on the raw data. The acronym ETL refers to data extraction-transformation-loading. The pre-processing process may include data aggregation, data screening, data integration, and format conversion.

The data aggregation may include the following. The collected data includes the data of different categories, i.e., the machine performance data, the network characteristics data, and the quality monitoring data. The collected data of the different categories are scattered. Thus, the data of a same type may be aggregated together. For example, all the machine performance data are aggregated together. In one embodiment, the data of a same category may be aggregated together according data dimensions. For example, the machine performance data may be aggregated according to the data dimensions such as the CPU utilization rate, and the memory utilization rate, etc. As such, the data of the CPU utilization rate dimension may be aggregated together and the data of the memory utilization rate dimension may be aggregated together. When the data of a same dimension are aggregated together, the data may be sorted in the order of collection cycles.

The data screening may include the following. Because the collected machine performance data, the network characteristics data, and the quality monitoring data may be missing or corrupted, the collected data may be cleansed and screened. Firstly, missing values and corrupted values may be screened. The missing values may be screened directly from the raw data. The corrupted values may be screened by using a clustering algorithm or configuring a confidence range after the collected data are standardized. The missing values and the corrupted values will be replaced with correct values. A replacing process may employ a k-NN method or data collected in adjacent collection cycles. For example, when the data collected in the adjacent collection cycles are employed in the replacing process, a missing value or a corrupted value of the CPU utilization rate collected at a node A in a current collection cycle may be replaced with the CPU utilization rate collected at the node A in a preceding collection cycle.

The data integration may include the following. After the collected data are aggregated and screened, the machine performance data, the network characteristics data, and the quality monitoring data collected in a same collection cycle may be correlated to obtain a training dataset. The training dataset may be used to learn a non-linear relationship among the machine performance data, the network characteristics data, and the quality monitoring data. A process of establishing the training dataset based on the machine performance data, the network characteristics data, and the quality monitoring data may include, determining the eigenvalue based on the machine performance data and the network characteristics data, determining a tag based on the quality monitoring data, and establishing the training dataset based on the eigenvalue and the tag.

The format conversion may include the following. Because an artificial intelligence learning system (such as TensorFlow) may be used to establish a deep neural network model, a format of the integrated data, i.e., the training dataset may be converted to a TFRecod format, thereby facilitating model data retrieval.

A process of establishing the training dataset is described in detail below.

Step 302: determining an eigenvalue based on the machine performance data and the network characteristics data.

In one embodiment, the eigenvalue, i.e., the eigenvalue relevant to assessing the service quality, for the model training may be selected by using a statistical method or in combination with empirical data. In one embodiment, the eigenvalue of the machine performance data may include the machine performance data, one or more of mean values, median values, or variance values of various dimensions of the machine performance data (e.g., mean value, median value, or variance value of the CPU utilization rate), the network characteristics data, and one or more of mean values, median values, or variance values of various dimensions of the network characteristics data (e.g., mean value, median value, or variance value of the ping data). The calculation of the mean values, the median values, or the variance values of various dimensions of the data may be based on a granularity of the CDN system and a granularity of the collection cycles. For example, the mean value of the CPU utilization may be an average of the CPU utilization rates collected from all service node in a same CDN system in one collection cycle. The eigenvalue may be a temporal eigenvalue. The machine performance data and the network characteristics data collected in each collection cycle may correspond to the eigenvalue of one temporal step.

Step 303: determining target quality data based on the quality monitoring data.

The assessment indicators of the service quality may directly reflect the level of the service quality. Different service types may require different assessment indicators to reflect the level of the service quality. The assessment indicators corresponding to the service type applicable for the service quality assessment model may be used to determine the target quality data. A process of determining the target quality data based on the quality monitoring data may include: determining the assessment indicators of the service quality based on the service type applicable for the service quality assessment model, using the quality monitoring data to calculate values of the assessment indicators, and determining the values of the assessment indicators as the target quality data. For example, the pausing rate may be selected as the assessment indicator for the service quality assessment model applicable for an on-demand service. The pausing rate calculated based the quality monitoring data may be used as the target quality data for the model training. The embodiments of the present invention do not limit the assessment indicators used in assessing quality data for the model training.

The collected quality monitoring data may include a large amount of raw data and may be unable to intuitively reflect the level of the service quality. Thus, a series of calculations may be performed to obtain the target quality data to reflect the level of the service quality. The calculated target quality data may be used as the tag for performing the model training.

Step 304: establishing a training dataset based on the eigenvalue and the target quality data.

After the eigenvalue and the target quality data are obtained based on the raw data, the eigenvalue and the target quality data may be used to establish a training sample. Each training sample may include the eigenvalues and the corresponding target quality data of *m* number of temporal steps, where *m* is a positive integer, and each training sample corresponds to one target quality data. *m* may be configured based on empirical data or self-study. The embodiments of the present invention do not limit *m*. In one embodiment, before the eigenvalue and the target quality data are calculated based on the raw data, the raw data may be aggregated based on a number of the temporal steps included in the training sample. In other words, the raw data collected in *m* number of collection cycles may be aggregated together. The machine performance data and the network characteristics data collected in each collection cycle may be used to determine the eigenvalue and the quality monitoring data collected in *m* number of collection cycles may be used to determine the target quality data. The eigenvalues and the target quality data may be used to obtain the training samples of *m* number of the temporal steps. The eigenvalue of each training sample may be

expressed as:

$$X = \begin{Bmatrix} x_{1,t1} & x_{2,t1} & \cdots & x_{n,t1} \\ x_{1,t2} & x_{2,t2} & \cdots & x_{n,t2} \\ \cdots & \cdots & \cdots & \cdots \\ x_{1,tm} & x_{2,tm} & \cdots & x_{n,tm} \end{Bmatrix},$$

where $x_{1,ti} \sim x_{n,ti}$ represents the eigenvalue of ith temporal step, $1 \leq i \leq m$, and the eigenvalue of the $i$th temporal step includes the machine performance data, one or more of the mean values, the median values, or the variance values of various dimensions of the machine performance data, the network characteristics data, and one or more of the mean values, the median values, or the variance values of various dimensions of the network.

The collected raw data may be used to obtain a large amount of the training samples. The training samples may be divided into the training datasets and testing datasets according to a preset split ratio for the model training.

Step 305: using the training dataset to train a deep neural network model to obtain a service quality assessment model.

In one embodiment, the deep neural network model may be a deep residual network and may use the artificial intelligence learning system to establish the deep residual network. The deep residual network may be a deep neural network constructed by a residual neural network. The deep residual network may be capable of eliminate an issue of a traditional deep neural network where a training error increases as a number of network layers increases. As the number of the network layers increases, the training error of the deep residual network may gradually decrease. Thus, a problem of model degradation may be solved, and training efficiency may be improved. In one embodiment, the deep neural network may include an input layer, a first total connection layer, a convolution layer, a residual block layer, a second total connection layer, and an output layer. A number of residual blocks in the residual layer may be approximately between 10 and 20.

In one embodiment, a process of training the deep neural network model may include an offline training process and an online training process. The offline training process may include the following. History data accumulated over a long period of time may be used to establish the training dataset and the testing dataset. Then, the training dataset established using the history data may be used to establish the deep neural network model. After a training process is completed, an effectiveness of fitting a trained model is validated using the testing dataset. If the effectiveness does not satisfy a preset requirement, hyperparameters may be adjusted and the offline training process is repeated iteratively. Otherwise, the offline training process is terminated and the service quality assessment model that has the effectiveness of model fitting satisfying the preset requirement is obtained. The hyperparameters may include a learning rate, a number of neurons, a number of neural layers, and a number of residual blocks, etc. After the offline training process is completed, the constantly changing online environment may require periodical training and improvement on the model obtained in the offline training process by using online real-time data. In other words, the training dataset established based on the real-time data may be used to periodically train the service quality assessment model to optimize the hyperparameters of the service quality assessment model. Thus, the service quality assessment model may be updated in real-time by performing an online learning process based on the online real-time data.

In either the offline training process or the online training process, using the training dataset to train the deep neural network model may include the following. The eigenvalue of the training dataset may be inputted to the first total connection layer through the input layer, and then may be divided and compressed to output new features. The new features outputted from the first total connection layer may be inputted to the convolution layer having a plurality of channels. For example, in a 1*1 convolution layer, a convolution process may be performed. As such, without compressing original features, a non-linear transformation may be added to improve network expression ability and to increase the plurality of channels to subsequently connect with the residual blocks. The data outputted from the convolution layer may be inputted in turn to a preset number of the residual blocks for further processing. The data outputted from the residual blocks may be inputted to the second total connection layer to perform the non-linear transformation to obtain the quality data. The quality data may be outputted through the output layer. An error between the quality data outputted from the output layer and the target quality data may be determined. The error may be expressed in a loss function. The error may be backward propagated to optimize the hyperparameters of the model. When the error is inputted to the model for the backward propagation, a partial differentiation may be performed on the hyperparameters of the model (including weights and offsets), and then the hyperparameters may be adjusted to optimize the model based on results of the partial differentiation.

The training dataset may include a plurality of training samples. Using the training dataset to train the deep residual network may include the following. The eigenvalues of the training samples may be inputted in turn to the deep residual network to obtain the quality data. For example, there are $p$ number of training samples. An eigenvalue of the first training sample is inputted to the input layer, the first total connection layer, the convolution layer, the residual blocks, the second total connection layer, and the output layer. Then, a succeeding training sample is inputted to the input layer, the first total connection layer, the convolution layer, the residual blocks, the second total connection layer, and the output layer. So on so forth until the $p$th training sample is inputted to the input layer, the first total connection layer, the convolution layer, the residual blocks, the second total connection layer, and the output layer to obtain results including $p$ number of the quality data. Errors between the $p$ number of the quality data and the $p$ number of the target quality data may be determined. Then, the errors may be backward propagated to optimize the hyperparameters of the model.

The data outputted from the convolution layer may be inputted in turn to the plurality of residual blocks for further processing. The plurality of residual blocks may process the inputted data similarly or differently. A residual block may process the inputted data in the following manner. The data inputted to the residual block may be inputted in turn to a 1 * 1 convolution layer having $a$ number of the channels, a 1*3 convolution layer having $b$ number of the channels, and a 1*1 convolution layer having $c$ number of the channels, where $a$, $b$, and $c$ are positive integers. The data outputted from the 1*1 convolution layer having $c$ number of the channels and the data inputted to the 1*1 convolution layer having $a$ number of the channels may be summed together. The summed data may be excited by a Relu function.

For example, when the data outputted from the convolution layer is inputted to the first residual block, the inputted data may be inputted in turn to the 1*1 convolution layer having $a$ number of the channels, the 1*3 convolution layer having $b$ number of the channels, and the 1*1 convolution layer having $c$ number of the channels, where $a$, $b$, and $c$ are positive integers. The number $a$ is equal to the number of the channels of the inputted data. The data outputted from the 1*1 convolution layer having $c$ number of the channels and the data inputted to the 1*1 convolution layer having $a$ number of the channels may be summed together. The summed data may be excited by the Relu function. The excited data may be inputted to the second residual block. The excited data outputted from the second residual block may be inputted to the third residual block. So on so forth until all the residual blocks are traversed. The remaining residual blocks other than the first residual block may process the data in a same or different manner as the first residual block.

In one embodiment, the residual blocks may transform an original learning task of identity map $F(x) = x$ to a learning task of identity map $F(x) = 0$ by adding residual channels, so that the deep neural network is more likely to learn the identity map and degradation of the deep neural network may be prevented. Further, because the residual blocks are introduced, a learning network may be configured to be very deep. The deep learning network may be desired for learning from the machine performance data, the network characteristics data, and the quality monitoring data. A learned relationship may be applied to a service quality assessment on other application services of a same service type. In one embodiment, the deep residual network may be a convolutional neural network (CNN). Because convolution calculation is computationally intensive, GPU resources may be fully used to solve a problem that a recurrent neural network (RNN) is unable to fully utilize the GPU resources. From the perspective of training efficiency, the CNN converges much quicker than the RNN. Thus, iterative examinations may be quickly performed in training validation, and time cost of the iterative examinations may be reduced.

In one embodiment, the training samples may be divided into a plurality of batches for a model training process. Each batch of the training samples may constitute one training dataset. The model training process may be performed as previously described to update the hyperparameters of the model. For example, the first batch of the training samples may be used to train and update the hyperparameters of the model. The second batch of the training samples may be used to train and update the hyperparameters of the model. The remaining batches of the training samples may be inputted in turn to train until the last batch of the training samples is inputted to train.

The embodiments of the present invention may have the following beneficial effects.

(1) In the embodiments of the present invention, indicators such as the machine performance data and the network characteristics data may be correlated with service quality through a feature engineering function of the deep neural network. Training is performed in combination with backward propagation to fit the non-linear relationship. Time consumed in manually performing feature engineering is reduced. At the same time, an accuracy of the service quality assessment is improved.

(2) The model according to the embodiments of the present invention may constantly adapt to the changing online real-time data by adopting an incremental training method while combining more dimensional features for training. As such, a service cluster having a better service quality may be determined in real-time through model prediction and may be recommended to a dispatching system to ensure the system to operate stably with high quality services.

(3) In the embodiments of the present invention, the machine performance data, the network characteristics data, and the quality monitoring data may be used to train the model to learn the non-linear relationship among the machine performance data and the network characteristics data. When the model is used to assess the service quality of the service system, only the machine performance data and the network characteristics data of the service system are required to be inputted. Compared with the method of assessing the service quality by analyzing the server access logs, the present invention may reduce an amount of data to be inputted, substantially reduce the computing resource and bandwidth required by the service quality assessment, increase an efficiency of the service quality assessment, and reduce operation cost. Because the data to be inputted to the model are decoupled from specific businesses, a general-purpose standard may be formed for the service quality assessment, thereby facilitating management of any service system.

(4) In the embodiments of the present invention, residual blocks are introduced in the deep neural network model to mitigate network degradation caused by a substantial network depth. As such, the deep neural network may be configured to have the substantial network depth to facilitate the deep neural network to transform the machine performance data and the network characteristics data to higher-level features. The higher-level features may be used to learn the service quality of the limited number of the application services. The learned model may use the machine performance data and the network characteristics data as model input without relying on the quality monitoring data to determine the assessment indicators of the service quality. Thus, the present invention may be used in the service quality assessment of the application services of which the assessment indicators are impossible or difficult to be determined precisely.

After the service quality assessment model is obtained, the service quality assessment model may be used to assess the service quality of the CDN system. The following describes a process of using the service quality assessment model to assess the service quality.

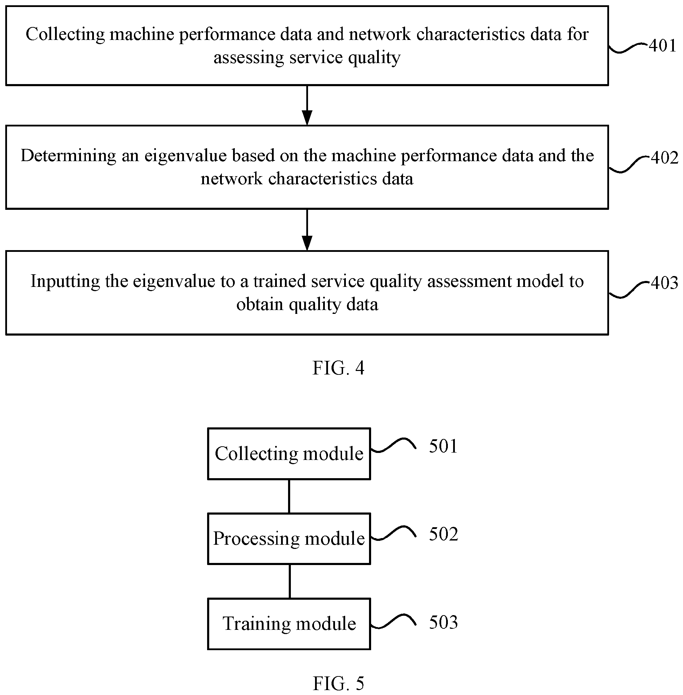

FIG. 4 illustrates a flow chart of an exemplary service quality assessment method according to disclosed embodiments. The method may be applied to the quality assessment node and may be executed by the quality assessment node. The method may include the following steps.

Step 401: collecting machine performance data and network characteristics data for assessing service quality.

The quality assessment node may collect the machine performance data and the network characteristics data in the service system on which the service quality is assessed. The collected machine performance data and the network characteristics data may be used in the service quality assessment. When collecting the raw data, the quality assessment node may collect the data for a preset number of the collection cycles in the fixed cycle. The preset number of the collection cycles may be greater than or equal to a number of required sampling temporal steps. For example, when the model is trained, 10 temporal steps of the data may be used as the training samples.

Step 402: determining an eigenvalue based on the machine performance data and the network characteristics data.

This step is similar to calculating the eigenvalue in the previously described model training process and will not be repeated herein.

Step 403: inputting the eigenvalue to a trained service quality assessment model to obtain quality data.

Eigenvalues for a preset number of temporal steps may be selected from the calculated eigenvalues to be inputted to the trained service quality assessment model. After calculation is performed by the service quality assessment model, a service quality assessment result may be outputted. The number of the temporal steps for the eigenvalues of the service quality assessment may be equal to the number of the temporal steps included in the training samples for the model training process.

After the service quality assessment model is deployed to an online application, further testing and training may be performed periodically to optimize the hyperparameters of the model and to improve the accuracy of the model.

The embodiments of the present invention may have the following beneficial effects.

(1) In the embodiments of the present invention, indicators such as the machine performance data and the network characteristics data may be correlated with service quality through a feature engineering function of the deep neural network. Training is performed in combination with backward propagation to fit the non-linear relationship. Time consumed in manually performing feature engineering is reduced. At the same time, an accuracy of the service quality assessment is improved.

(2) The model according to the embodiments of the present invention may constantly adapt to the changing online real-time data by adopting an incremental training method while combining more dimensional features for training. As such, a service cluster having a better service quality may be determined in real-time through model prediction and may be recommended to a dispatching system to ensure the system to operate stably with high quality services.

(3) In the embodiments of the present invention, the machine performance data, the network characteristics data, and the quality monitoring data may be used to train the model to learn the non-linear relationship among the machine performance data and the network characteristics data. When the model is used to assess the service quality of the service system, only the machine performance data and the network characteristics data of the service system are required to be inputted. Compared with the method of assessing the service quality by analyzing the server access logs, the present invention may reduce an amount of data to be inputted, substantially reduce the computing resource and bandwidth required by the service quality assessment, increase an efficiency of the service quality assessment, and reduce operation cost. Because the data to be inputted to the model are decoupled from specific businesses, a general-purpose standard may be formed for the service quality assessment, thereby facilitating management of any service system.

(4) In the embodiments of the present invention, residual blocks are introduced in the deep neural network model to mitigate network degradation caused by a substantial network depth. As such, the deep neural network may be configured to have the substantial network depth to facilitate the deep neural network to transform the machine performance data and the network characteristics data to higher-level features. The higher-level features may be used to learn the service quality of the limited number of the application services. The learned model may use the machine performance data and the network characteristics data as model input without relying on the quality monitoring data to determine the assessment indicators of the service quality. Thus, the present invention may be used in the service quality assessment of the application services of which the assessment indicators are impossible or difficult to be determined precisely.

FIG. 5 illustrates a block diagram of an exemplary training apparatus for the service quality assessment model according to disclosed embodiments. The apparatus may be configured at the model training node or may be the model training node itself. The apparatus may include a collecting module 501, a processing module 502, and a training module 503.
The collecting module 501 is configured to collect the machine performance data, the network characteristics data, and the quality monitoring data of the service nodes according to the fixed cycle. The processing module 502 is configured to determine the eigenvalue based on the machine performance data and the network characteristics data. The processing module 502 is further configured to determine the target quality data based on the quality monitoring data. The processing module 502 is further configured to use the eigenvalue and the target quality data to establish the training dataset. The training module 503 is configured to use the training dataset to construct the service quality assessment model.
In one embodiment, each service quality assessment model may be suitable for the quality assessment of a service type. Correspondingly, the collecting module 501 is configured to collect the quality monitoring data corresponding to one or more application services from the service nodes according to the fixed cycle. The one or more application services belong to the service type applicable for the service quality assessment model.
In one embodiment, the machine performance data include the CPU utilization rate, the memory utilization rate, and the input/output information. The network characteristics data include the ping data, the poll data, and the downloading speed.
In one embodiment, the monitoring node sends the testing signals to the service nodes periodically to obtain the network characteristics data. Correspondingly, the collecting module 501 is configured to collect the network characteristics data of the service nodes from the monitoring node according to the fixed cycle.
In one embodiment, the processing module 502 is further configured to screen the missing values and the corrupted values of the machine performance data, the network characteristics data, and the quality monitoring data and to replace the missing values and the corrupted values with the correct values.
In one embodiment, the processing module 502 is further configured to use the clustering algorithm or configuring the confidence range after the collected data are standardized to screen the missing values and the corrupted values of the machine performance data, the network characteristics data, and the quality monitoring data and to use the k-NN method or the data collected in the adjacent collection cycles to replace the corrupted values.
In one embodiment, the eigenvalue may include the machine performance data, one or more of mean values, median values, or variance values of various dimensions of the machine performance data, the network characteristics data, and one or more of mean values, median values, or variance values of various dimensions of the network characteristics data.
In one embodiment, the processing module 502 is further configured to determine the assessment indicators of the service quality based on the service type applicable for the service quality assessment model, to use the quality monitoring data to calculate values of the assessment indicators, and to determine the values of the assessment indicators as the target quality data.
In one embodiment, the training module 503 is further configured to use the training dataset to train the deep neural network model to construct the service quality assessment model. The deep neural network is the deep residual network.
In one embodiment, the training dataset may include a plurality of training samples. Each training sample may include the eigenvalue of $m$ number of the temporal steps and the target quality data, where $m$ is a positive integer. The training module 503 is further configured to input the eigenvalues of the training samples to the deep residual network in turn to obtain the quality data, to determine the errors between the quality data and the target quality data, and to backward propagate the errors to optimize the hyperparameters of the model.
In one embodiment, the deep residual network may include the input layer, the first total connection layer, the convolution layer, the preset number of the residual blocks, the second total connection layer, and the output layer.

In one embodiment, the training module 503 is further configured to input the eigenvalue of the training dataset to the first total connection layer to be divided and compressed to output the new features.

In one embodiment, the convolution layer may have a plurality of channels.

In one embodiment, the training module 503 is further configured to input the data outputted from the convolution layer to the preset number of the residual blocks in turn for further processing. A residual block may process the inputted data in the following manner. The data inputted to the residual block may be inputted in turn to a 1*1 convolution layer having $a$ number of the channels, a 1*3 convolution layer having $b$ number of the channels, and a 1*1 convolution layer having $c$ number of the channels, where $a$, $b$, and $c$ are positive integers. The data outputted from the 1*1 convolution layer having $c$ number of the channels and the data inputted to the 1*1 convolution layer having $a$ number of the channels may be summed together. The summed data may be excited by a Relu function.

In one embodiment, the training module 503 is further configured to input the data outputted from the last one of the residual blocks to the second total connection layer to perform the non-linear transformation to obtain the quality data.

In one embodiment, the processing module 502 is further configured to establish the testing dataset based on the eigenvalues and the target quality data. The training module 503 is further configured to use the training dataset established using the history data to perform the model training, to use the testing dataset to validate the effectiveness of fitting the trained model after the training process is completed, to adjust the hyperparameters to repeat the training process if the effectiveness does not satisfy the preset requirement, and to terminate the training process to obtain the service quality assessment model if the effectiveness satisfies the present requirement. The training module 503 is further configured to use the training dataset established based on the real-time data to periodically train the service quality assessment model to optimize the hyperparameters of the service quality assessment model.

In one embodiment, the relationship between the data inputted to the service quality assessment model and the result outputted from the service quality assessment model may be a non-linear relationship.

It should be noted that the training apparatus based on the service quality assessment model provided by the embodiments is illustrated as the connections are established based on the described partition of the function modules. In practical applications, the training apparatus may be constructed as needed based on a different partition of the function modules. That is, the internal structure of the training apparatus may include different function modules to implement all or a portion of the described functions. In addition, the training apparatus based on the service quality assessment model provided by the embodiments and the training method based on the service quality assessment model provided by the embodiments belong to a same inventive idea. The implementation details of the training apparatus may be referred to the embodiments of the training method and will not be repeated herein. Moreover, the training apparatus and the training method based on the service quality assessment model provided by the embodiments may have the same beneficial effects. The beneficial effects of the embodiments of the training apparatus based the service quality assessment model may be referred to the beneficial effects of the embodiments of the training method based on the service quality assessment model and will not be repeated herein.

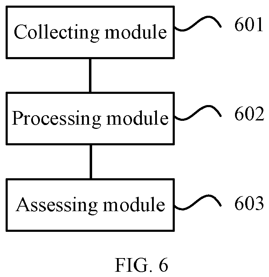

FIG. 6 illustrates a block diagram of an exemplary service quality assessment apparatus according to disclosed embodiments. The apparatus may be configured at the quality assessment node or may be the quality assessment node itself. The apparatus may include a collecting module 601, a processing module 602, and an assessing module 603.

The collecting module 601 is configured to collect the machine performance data and the network characteristics data for assessing the service quality. The processing module 602 is configured to determine the eigenvalue based on the machine performance data and the network characteristics data. The assessing module 603 is configured to input the eigenvalue to the trained service quality assessment model to obtain the quality data.

It should be noted that the training apparatus based on the service quality assessment model provided by the embodiments is illustrated as the connections are established based on the described partition of the function modules. In practical applications, the training apparatus may be constructed as needed based on a different partition of the function modules. That is, the internal structure of the training apparatus may include different function modules to implement all or a portion of the described functions. In addition, the training apparatus based on the service quality assessment model provided by the embodiments and the training method based on the service quality assessment model provided by the embodiments belong to a same inventive idea. The implementation details of the training apparatus may be referred to the embodiments of the training method and will not be repeated herein. Moreover, the training apparatus and the training method based on the service quality assessment model provided by the embodiments may have the same beneficial effects. The beneficial effects of the embodiments of the training apparatus based the service quality assessment model may be referred to the beneficial effects of the embodiments of the training method based on the service quality assessment model and will not be repeated herein.

It should be understood by those skilled in the art that all or a portion of the steps of the above described embodiments may be implemented in hardware or in computer program to instruct relevant hardware. The computer program may be stored in a computer readable storage medium. The storage medium may be a read-only memory, a magnetic disk, or an optical disk, etc.

It should be understood by those skilled in the art that the foregoing are merely certain preferred embodiments of the present invention and are not intended to limit the present invention. Without departing from the spirit and principles of the present invention, any modifications, equivalent substitutions, and improvements, etc. shall fall within the scope of the present invention.

**Claims**

1. A training method for a service quality assessment model applicable for a model training node, comprising:

   collecting machine performance data, network characteristics data, and quality monitoring data of service nodes according to a fixed cycle;
   determining an eigenvalue based on the machine performance data and the network characteristics data;
   determining target quality data based on the quality monitoring data;
   using the eigenvalue and the target quality data to establish a training dataset; and
   using the training dataset to construct the service quality assessment model.

2. The method of claim 1, wherein:

   each service quality assessment model is applicable for assessing a service type; and correspondingly, collecting the quality monitoring data of the service nodes according to the fixed cycle includes:
   collecting, according to the fixed cycle, the quality monitoring data of the service nodes corresponding to one or more application services belonging to a service type applicable for the service quality assessment model.

3. The method of claim 1, wherein:
   the machine performance data include a CPU utilization rate, a memory utilization rate, and input/output information; and the network characteristics data include ping data, poll data, and a downloading speed.

4. The method of claim 1, wherein:

   a monitoring node periodically sends testing signals to the service nodes to obtain the network characteristics data; and
   correspondingly, collecting the network characteristics data of the service nodes according to the fixed cycle includes:
collecting the network characteristics data of the service nodes from the monitoring node according to the fixed cycle.

5. The method of claim 1, before determining the eigenvalue based on the machine performance data and the network characteristics data, further including:

   screening missing values and corrupted values from the machine performance data, the network characteristics data, the quality monitoring data; and
   replacing the missing values and the corrupted values with correct values.

6. The method of claim 5, wherein:

   screening the missing values and the corrupted values from the machine performance data, the network characteristics data, the quality monitoring data includes using a clustering algorithm or configuring a confidence range after the collected data are standardized to screen the missing values and the corrupted values from the machine performance data, the network characteristics data, the quality monitoring data; and
   replacing the corrupted values with the correct values includes using a k-NN method or data collected in adjacent collection cycles to replace the corrupted values.

7. The method of claim 1, wherein:
   the eigenvalue includes the machine performance data, one or more of mean values, median values, or variance values of various dimensions of the machine performance data, the network characteristics data, and one or more of mean values, median values, or variance values of various dimensions of the network characteristics data.

8. The method of claim 1, wherein determining the target quality data based on the quality monitoring data includes:

   determining assessment indicators of service quality based on the service type applicable for the service quality assessment model; and
   using the quality monitoring data to calculate values of the assessment indicators and determining the values of the assessment indicators as the target quality data.

9. The method of claim 1, wherein using the training dataset to construct the service quality assessment model includes:

using the training dataset to train a deep neural network to construct the service quality assessment model, wherein the deep neural network is a deep residual network.

10. The method of claim 9, wherein:

the training dataset includes a plurality of training samples; and
each training sample includes the eigenvalue of $m$ number of the temporal steps and the target quality data, wherein $m$ is a positive integer.

11. The method of claim 10, wherein using the training dataset to train the deep residual network includes:

inputting the eigenvalues of the training samples to the deep residual network in turn to obtain quality data;
determining an error between the quality data and the target quality data; and
backward propagating the error to optimize hyperparameters of a model.

12. The method of claim 9, wherein:
the deep residual network includes an input layer, a first total connection layer, a convolution layer, a preset number of residual blocks, a second total connection layer, and an output layer.

13. The method of claim 12, wherein using the training dataset to train the deep residual network includes:
inputting the eigenvalues of the training samples to the first total connection layer to be divided and compressed, and outputting new features.

14. The method of claim 12, wherein:
the convolution layer has a plurality of channels.

15. The method of claim 12, wherein using the training dataset to train the deep residual network further includes:
inputting data outputted from the convolution layer to the preset number of residual blocks in turn for further processing, wherein data processing in each residual block includes:

inputting, in turn, data inputted to the residual block to a 1*1 convolution layer having $a$ number of channels, a 1*3 convolution layer having $b$ number of channels, and a 1*1 convolution layer having $c$ number of channels, wherein $a$, $b$, and $c$ are positive integers;
summing data outputted from the 1*1 convolution layer having $c$ number of channels and data inputted to the 1*1 convolution layer having $a$ number of channels; and
stimulating the summed data by a Relu function.

16. The method of claim 12, wherein using the training dataset to train the deep residual network further includes:
inputting data outputted from the last one of the preset number of residual blocks to the second total connection layer to perform a non-linear transformation to obtain the quality data.

17. The method of claim 1, wherein:

the method further includes using the eigenvalue and the target quality data to establish a testing dataset; and
using the training dataset to construct the service quality assessment model includes:

according to the training dataset established based on history data, performing model training;
according to the testing dataset, validating an effectiveness of fitting a trained model;
if the effectiveness does not satisfy a preset requirement, adjusting the hyperparameters and repeating the model training iteratively;
if the effectiveness satisfies the preset requirement, terminating the model training to obtain the service quality assessment model; and
using the training dataset established based on real-time data to continue to train the service quality assessment model to optimize the hyperparameters of the service quality assessment model.

18. The method of claim 1, wherein:
a relationship between inputted data and outputted result established by the service quality assessment model is a non-linear relationship.

19. The method of claim 1, wherein:
the model training node is a single server or a group of servers.

20. A training apparatus for a service quality assessment model, comprising:

a collecting module configured to collect machine performance data, network characteristics data, and quality monitoring data of service nodes according to a fixed cycle;
a processing module configured to determine an eigenvalue based on the machine performance data and the network characteristics data, to determine target quality data based on the quality monitoring data, and to use the eigenvalue and the target quality data to establish a training dataset; and

a training module configured to use the training dataset to construct the service quality assessment model.

21. The apparatus of claim 20, wherein:

   each service quality assessment model is applicable for assessing a service type; and correspondingly, the collecting module is configured to:
   collect, according to the fixed cycle, the quality monitoring data of the service nodes corresponding to one or more application services belonging to a service type applicable for the service quality assessment model.

22. The apparatus of claim 20, wherein the processing module is further configured to:

   screen missing values and corrupted values from the machine performance data, the network characteristics data, the quality monitoring data; and
   replace the missing values and the corrupted values with correct values.

23. The apparatus of claim 20, wherein:
   the eigenvalue includes the machine performance data, one or more of mean values, median values, or variance values of various dimensions of the machine performance data, the network characteristics data, and one or more of mean values, median values, or variance values of various dimensions of the network characteristics data.

24. The apparatus of claim 20, wherein the training module is further configured to:
   use the training dataset to train a deep neural network to construct the service quality assessment model, wherein the deep neural network is a deep residual network.

25. The apparatus of claim 24, wherein:

   the training dataset includes a plurality of training samples;
   each training sample includes the eigenvalue of m number of the temporal steps and the target quality data, wherein m is a positive integer; and
   the training module is further configured to:

      input the eigenvalues of the training samples to the deep residual network in turn to obtain quality data;
      determine an error between the quality data and the target quality data; and
      backward propagate the error to optimize hyperparameters of a model.

26. The apparatus of claim 24, wherein:
   the deep residual network includes an input layer, a first total connection layer, a convolution layer, a preset number of residual blocks, a second total connection layer, and an output layer.

27. The apparatus of claim 26, wherein the training module is further configured to:
   input the eigenvalues of the training samples to the first total connection layer to be divided and compressed, and output new features.

28. The apparatus of claim 26, wherein:
   the convolution layer has a plurality of channels.

29. The apparatus of claim 26, wherein the training module is further configured to:
   input data outputted from the convolution layer to the preset number of residual blocks in turn for further processing, wherein data processing in each residual block includes:

      inputting, in turn, data inputted to the residual block to a 1*1 convolution layer having $a$ number of channels, a 1*3 convolution layer having $b$ number of channels, and a 1*1 convolution layer having $c$ number of channels, wherein $a$, $b$, and $c$ are positive integers;
      summing data outputted from the 1*1 convolution layer having $c$ number of channels and data inputted to the 1*1 convolution layer having $a$ number of channels; and
      stimulating the summed data by a Relu function.

30. The apparatus of claim 26, wherein the training module is further configured to:
   input data outputted from the last one of the preset number of residual blocks to the second total connection layer to perform a non-linear transformation to obtain the quality data.

31. The apparatus of claim 20, wherein:

   the processing module is further configured to use the eigenvalue and the target quality data to establish a testing dataset; and
   the training module is further configured to:

      according to the training dataset established based on history data, perform model training;
      according to the testing dataset, validate an effectiveness of fitting a trained model;
      if the effectiveness does not satisfy a preset requirement, adjust the hyperparameters and repeating the model training iteratively;
      if the effectiveness satisfies the preset requirement, terminate the model training to obtain the service quality assessment model; and

use the training dataset established based on real-time data to continue to train the service quality assessment model to optimize the hyperparameters of the service quality assessment model.

| Service node | ... | Service node | ... | Service node |

Monitoring node

Model training node

FIG. 1

| Service node | ... | Service node | ... | Service node |

Monitoring node

Quality assessment node

FIG. 2

Collecting machine performance data, network characteristics data, and quality monitoring data in a fixed cycle ⟶301

Determining an eigenvalue based on the machine performance data and the network characteristics data ⟶302

Determining target quality data based on the quality monitoring data ⟶303

Establishing a training dataset based on the eigenvalue and the target quality data ⟶304

Using the training dataset to train a deep neural network model to obtain a service quality assessment model ⟶305

FIG. 3

Collecting machine performance data and network characteristics data for assessing service quality — 401

Determining an eigenvalue based on the machine performance data and the network characteristics data — 402

Inputting the eigenvalue to a trained service quality assessment model to obtain quality data — 403

FIG. 4

Collecting module — 501

Processing module — 502

Training module — 503

FIG. 5

Collecting module ⌇ 601

Processing module ⌇ 602

Assessing module ⌇ 603

FIG. 6

## INTERNATIONAL SEARCH REPORT

| International application No. |
| --- |
| **PCT/CN2018/112681** |

| A. | CLASSIFICATION OF SUBJECT MATTER |
| --- | --- |
| | G06F 17/50(2006.01)i; H04L 12/24(2006.01)i |

According to International Patent Classification (IPC) or to both national classification and IPC

| B. | FIELDS SEARCHED |
| --- | --- |

Minimum documentation searched (classification system followed by classification symbols)

G06F; H04L

Documentation searched other than minimum documentation to the extent that such documents are included in the fields searched

Electronic data base consulted during the international search (name of data base and, where practicable, search terms used)

CNPAT, CNKI, WPI, EPODOC: 服务质量, 评价, 评估, 模型, 内容分发网络, 训练, 机器性能, 网络特征, 训练集, 目标, 神经网络, 特征工程, 反向传播, 赵瑞, QOS, CDN, evaluation, model, training, set, network characteristic, machine performance, target

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 105050132 A (BEIJING UNIVERSITY OF POSTS AND TELECOMMUNICATIONS) 11 November 2015 (2015-11-11) description, paragraphs [0063]-[0067], and figure 1 | 1-31 |
| A | CN 106384197 A (BEIJING XIELI ZHUCHENG FINANCE INFORMATION SERVICES CO., LTD.) 08 February 2017 (2017-02-08) entire document | 1-31 |
| A | CN 107395404 A (TENCENT TECHNOLOGY (SHENZHEN) CO., LTD.) 24 November 2017 (2017-11-24) entire document | 1-31 |
| A | CN 105046045 A (HOHAI UNIVERSITY) 11 November 2015 (2015-11-11) entire document | 1-31 |
| A | US 2017255867 A1 (PEARSON EDUCATION, INC.) 07 September 2017 (2017-09-07) entire document | 1-31 |

☑ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **03 July 2019** | **19 July 2019** |

| Name and mailing address of the ISA/CN | Authorized officer |
| --- | --- |
| **China National Intellectual Property Administration (ISA/ CN)** **No. 6, Xitucheng Road, Jimenqiao, Haidian District, Beijing 100088 China** | |
| Facsimile No. **(86-10)62019451** | Telephone No. |

Form PCT/ISA/210 (second sheet) (January 2015)

**INTERNATIONAL SEARCH REPORT**

International application No.

**PCT/CN2018/112681**

**C.    DOCUMENTS CONSIDERED TO BE RELEVANT**

| Category* | Citation of document, with indication, where appropriate, of the relevant passages | Relevant to claim No. |
|---|---|---|
| A | 李学森等 (LI, Xuesen et al.). "流媒体服务器性能评价模型 (Performance Evaluation Model of Streaming Media Server)"<br>计算机工程 (Computer Engineering), Vol. 35, No. 10, 31 May 2009 (2009-05-31),<br>entire document | 1-31 |

Form PCT/ISA/210 (second sheet) (January 2015)

EP 3 863 223 A1

## INTERNATIONAL SEARCH REPORT
### Information on patent family members

International application No.

**PCT/CN2018/112681**

| Patent document cited in search report | | | Publication date (day/month/year) | Patent family member(s) | Publication date (day/month/year) |
|---|---|---|---|---|---|
| CN | 105050132 | A | 11 November 2015 | None | |
| CN | 106384197 | A | 08 February 2017 | None | |
| CN | 107395404 | A | 24 November 2017 | None | |
| CN | 105046045 | A | 11 November 2015 | None | |
| US | 2017255867 | A1 | 07 September 2017 | None | |

Form PCT/ISA/210 (patent family annex) (January 2015)

23